(19) Europäisches Patentamt
European Patent Office
Office européen des brevets

(11) **EP 4 578 644 A1**

(12) **EUROPEAN PATENT APPLICATION**
published in accordance with Art. 153(4) EPC

(43) Date of publication:
**02.07.2025 Bulletin 2025/27**

(21) Application number: **23857116.0**

(22) Date of filing: **28.07.2023**

(51) International Patent Classification (IPC):
**B32B 15/04** (2006.01)  **G01N 23/2273** (2018.01)

(52) Cooperative Patent Classification (CPC):
**B32B 15/01; B32B 15/04; G01N 23/2273; G02B 5/20; G02B 5/30**

(86) International application number:
**PCT/JP2023/027719**

(87) International publication number:
**WO 2024/043000 (29.02.2024 Gazette 2024/09)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **26.08.2022 JP 2022135044**

(71) Applicant: **Sumitomo Chemical Company, Limited Tokyo 103-6020 (JP)**

(72) Inventors:
• **FUKUURA, Tomohiro**
  **Osaka-shi, Osaka 554-8558 (JP)**
• **MATSUMOTO, Kenji**
  **Osaka-shi, Osaka 554-8558 (JP)**

(74) Representative: **Vossius & Partner Patentanwälte Rechtsanwälte mbB Siebertstrasse 3 81675 München (DE)**

(54) **LAYERED BODY AND METHOD FOR PRODUCING SAME**

(57) To provide a layered body including a metal-based particle assembly layer including a plurality of metal-based particles and having excellent resistance to cleaning with a piranha solution. A layered body including a metal-based particle assembly layer including a plurality of metal-based particles disposed apart from each other, and a silicon atom-containing layer, in which the silicon atom-containing layer including a first surface, and the first surface having 20.0 at.% or less of a signal intensity of carbon atoms, the signal intensity being measured by X-ray photoelectron spectroscopy, is provided.

Fig. 1

EP 4 578 644 A1

## Description

BACKGROUND OF THE INVENTION

Field of the Invention

The present invention relates to a layered body including a metal-based particle assembly layer and a method of manufacturing the same.

Description of the Related Art

A technique of enhancing fluorescence using localized plasmon resonance of metal nanoparticles is known (e.g., JP-A-08-271431). JP-A-08-271431 states that a layered body including an island layer (2) containing a plurality of metal particles and a spacer film (5) covering the layer is used for an optochemical fluorescence sensor.

SUMMARY OF THE INVENTION

The layered body as described above may be washed with a piranha solution prior to subsequent steps such as surface modification of the layered body. An object of the present invention is to provide a layered body including a metal-based particle assembly layer including a plurality of metal-based particles and having excellent resistance to cleaning with a piranha solution, and a method of manufacturing the same.

The present invention provides a layered body and a method of manufacturing the same as follows.

[1] A layered body including:

a metal-based particle assembly layer including a plurality of metal-based particles disposed apart from each other; and
a silicon atom-containing layer,
in which the silicon atom-containing layer includes a first surface, and
the first surface has a signal intensity of carbon atoms of 20.0 at.% or less, the signal intensity being measured by X-ray photoelectron spectroscopy.

[2] The layered body according to [1], including:

a base member;
the metal-based particle assembly layer being disposed on a surface of the base member; and
the silicon atom-containing layer being disposed on the metal-based particle assembly layer,
in which the silicon atom-containing layer covers an entire surface of the metal-based particle assembly layer on a side opposite to the base member.

[3] The layered body according to [1] or [2], in which the silicon atom-containing layer is an amorphous layer.
[4] The layered body according to any one of [1] to [3], in which the silicon atom-containing layer is a wet coating layer.
[5] The layered body according to any one of [1] to [4], in which the silicon atom-containing layer has an average thickness of 10 nm or more and 300 nm or less.
[6] The layered body according to any one of [1] to [5], in which the plurality of metal-based particles comprise silver.
[7] The layered body according to any one of [1] to [6], in which

the plurality of metal-based particles have an average particle diameter within a range of 200 nm or more and 1600 nm or less, an average height within a range of 55 nm or more and 500 nm or less, and an aspect ratio within a range of 1 or more and 8 or less, the aspect ratio being defined as a ratio of the average particle diameter to the average height, and
each of the plurality of metal-based particles in the metal-based particle assembly layer is disposed based on an average distance from an adjacent metal-based particle among the plurality of metal-based particles within a range of 1 nm or more and 150 nm or less.

[8] The layered body according to [7], in which the aspect ratio is greater than 1.
[9] The layered body according to any one of [1] to [8], in which the first surface has an arithmetic mean roughness Ra of 10 nm or less, the arithmetic mean roughness being measured in conformity with JIS B 0601:2001.
[10] The layered body according to any one of [1] to [9], in which the first surface has an arithmetic mean roughness Ra of 15 nm or less, the arithmetic mean roughness Ra being measured in conformity with JIS B 0601:2001 after immersion for 30 minutes in a mixed liquid at a temperature of 25°C, the mixed liquid being obtained by mixing concentrated sulfuric acid having a concentration of 98 mass% and 30 mass% aqueous hydrogen peroxide solution at a volume ratio of 4 : 1.
[11] A method of manufacturing a layered body,

the layered body including a metal-based particle assembly layer including a plurality of metal-based particles being disposed apart from each other, and a silicon atom-containing layer,
the silicon atom-containing layer having a first surface, and
the first surface having a signal intensity of carbon atoms of 20.0 at.% or less, the signal intensity being measured by X-ray photoelectron spectroscopy,
the method including:

forming the metal-based particle assembly layer on a base member;
forming a coating layer by applying a silicon atom-containing layer-forming composition onto the base member on which the metal-based particle assembly layer is formed; and
heat-treating the coating layer at a temperature of 300°C or more and 800°C or less.

[12] The method according to [11], further including degreasing and cleaning the base member before the step of forming the metal-based particle assembly layer.

A layered body including a metal-based particle assembly layer including a plurality of metal-based particles and having excellent resistance to cleaning with a piranha solution, and a method of manufacturing the same can be provided.

BRIEF DESCRIPTION OF THE DRAWINGS

Fig. 1 is a sectional view schematically illustrating an example of a layered body according to the present invention;
Figs. 2A and 2B are scanning electron microscope (SEM) images (on scales of 10000x and 50000x) when a metal-based particle assembly layer obtained in Example 1 is viewed from directly above;
Fig. 3 is an atomic force microscope (AFM) image of the metal-based particle assembly layer obtained in Example 1;
Fig. 4 is an SEM image (50000x scale) of the layered body of Example 1 before a cleaning test with a piranha solution as viewed from a silicon atom-containing layer side;
Fig. 5 is an SEM image (50000x scale) of the layered body of Example 1 after the cleaning test with a piranha solution as viewed from the silicon atom-containing layer side;
Fig. 6 is an optical microscope image (700x scale) of the layered body of Example 1 before the cleaning test with a piranha solution as viewed from the silicon atom-containing layer side;
Fig. 7 is an optical microscope image (700x scale) of the layered body of Example 1 after the cleaning test with a piranha solution as viewed from the silicon atom-containing layer side;
Fig. 8 is an optical microscope image (700x scale) of the layered body of Example 2 after the cleaning test with a piranha solution as viewed from the silicon atom-containing layer side;
Fig. 9 is an optical microscope image (700x scale) of the layered body of Example 3 after the cleaning test with a piranha solution as viewed from the silicon atom-containing layer side; and
Fig. 10 is an optical microscope image (700x scale) of the layered body of Comparative Example 1 after the cleaning test with a piranha solution as viewed from the silicon atom-containing layer side.

DETAILED DESCRIPTION OF THE PREFERRED EMBODIMENTS

<Layered Body>

(1) Overview

A layered body according to the present invention (hereinafter, it is also simply referred to as a "layered body") includes a metal-based particle assembly layer including a plurality of metal-based particles disposed apart from each other, and a silicon atom-containing layer. The silicon atom-containing layer includes a first surface, and the signal intensity of carbon atoms at the first surface as measured by X-ray photoelectron spectroscopy is 20.0 at.% or less.

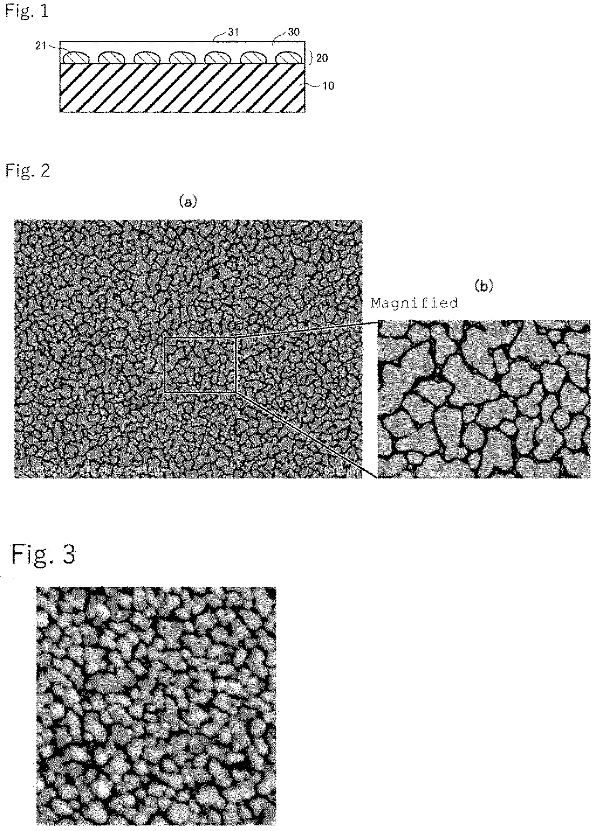

Fig. 1 is a sectional view schematically illustrating an example of the layered body. The layered body illustrated in Fig. 1 includes a base member 10, a metal-based particle assembly layer 20 disposed on the surface of the base member 10, and a silicon atom-containing layer 30 disposed on the metal-based particle assembly layer 20. The metal-based particle assembly layer 20 is an assembly of a plurality of metal-based particles 21, and is a layer including a plurality of metal-based particles 21 disposed apart from each other. The silicon atom-containing layer 30 includes a first surface 31, and the signal intensity of carbon atoms at the first surface 31 measured by X-ray photoelectron spectroscopy is 20.0 at.% or less.
According to the present invention, since the silicon atom-containing layer including the first surface in which the signal intensity of carbon atoms is 20.0 at.% or less is layered, a layered body excellent in resistance to cleaning with a piranha solution can be provided. The layered body can be applied to, for example, a sensor element or the like. A suitable example of the sensor element is a biosensor element.
The layered body may include a layer other than the base member 10, the metal-based particle assembly layer 20, and the silicon atom-containing layer 30. Examples of such a layer include a layer interposed between the metal-based particle assembly layer 20 and the silicon atom-containing layer 30, and a layer being layered on the silicon atom-containing layer 30.

(2) Metal-Based Particle Assembly Layer

The metal-based particle assembly layer 20 is a layer including a plurality of metal-based particles 21 disposed apart from each other, and is preferably a plasmonic structure. The "plasmonic structure" refers to a structure that can exhibit localized plasmon resonance. Plasmon is a compressional wave of free electrons generated by collective oscillation of the free electrons in a structure. When the layered body is applied to a sensor element, for example, the metal-based particle assembly layer 20 being a plasmonic structure can enhance the intensity of light emission (fluorescence or the like) from a luminescent substance that labels an analyte. Therefore, the layered body can be suitably used as an emission enhancing element for various sensor elements. Application of the layered body to a sensor element can improve sensitivity, quantitative accuracy, and/or reproducibility (stability) of quantitative results of the sensor element.

The metal-based particle assembly layer 20 preferably satisfies the following.

The plurality of metal-based particles 21 constituting the metal-based particle assembly layer 20 have an average particle diameter within a range of 200 nm or more and 1600 nm or less, an average height within a range of 55 nm or more and 500 nm or less, and an aspect ratio defined as a ratio of the average particle diameter to the average height within a range of 1 or more and 8 or less. Each of the plurality of metal-based particles 21 in the metal-based particle assembly layer 20 is disposed based on an average distance from an adjacent metal-based particle within a range of 1 nm or more and 150 nm or less.

The metal-based particle assembly layer 20 having a predetermined structure satisfying the above, and further the layered body including the metal-based particle assembly layer can exhibit the following characteristics [a] and [b]. These characteristics are considered to be exhibited by an interaction between localized plasmons of the plurality of metal-based particles 21 constituting the metal-based particle assembly layer 20.

[a] The range of effect of plasmon resonance exhibited by the metal-based particle assembly layer 20 is broad. As a result, for example, the applicable range of the emission enhancing effect by plasmon can be broadened. Thus, light emission of a luminescent substance within a range of, for example, several hundred nanometers (e.g., 200 nm) from the surface of the metal-based particle assembly layer 20 can also be enhanced.

[b] The metal-based particle assembly layer 20 exhibits strong plasmon resonance. As a result, for example, a strong emission enhancing effect can be obtained.

With regard to [a], the layered body according to the present invention can enhance the light emission of the luminescent substance disposed at a position apart from the metal-based particle assembly layer 20 by, for example, 10 nm or more, further several tens nanometers (e.g., 20 nm, 30 nm, or 40 nm) or more, still further 100 nm or more, or 200 nm or more. With regard to [b], the intensity of plasmon resonance exhibited by the layered body is not merely the sum of localized plasmon resonances of the individual metal-based particles at a specific wavelength, but is more than that. In the layered body, individual metal-based particles interact with each other, and strong plasmon resonance is exhibited. Such strong plasmon resonance is considered to be exhibited by an interaction between localized plasmons of the metal-based particles.

In general, when an absorption spectrum of a plasmonic structure is measured by absorptiometry, a plasmon resonance peak (hereinafter, also referred to as a "plasmon peak") is observed as a peak on the longest wavelength side in ultraviolet to visible light region. The intensity of the plasmon resonance of a plasmonic structure can be evaluated from the magnitude of the absorbance at the maximum wavelength of the plasmon peak. As the value of absorbance increases, the intensity of plasmon resonance also tends to increase. In the metal-based particle assembly layer 20 having the predetermined structure, the absorbance at the maximum wavelength of the plasmon peak on the longest wavelength side in the ultraviolet to visible light region can be 1 or more, further 1.5 or more, still further about 2 when the absorption spectrum is measured by the following absorptiometry.

The absorption spectrum of the plasmonic structure can be measured by absorptiometry. Specifically, the absorption spectrum is obtained by using an integrating sphere spectrophotometer and measuring the following two values of intensity. The first one is intensity $I$ of omnidirectionally transmitted light transmitted toward the metal-based particle assembly layer side when the back surface side of a glass substrate on which the metal-based particle assembly layer is layered (side opposite to the metal-based particle assembly layer) is irradiated with incident light in an ultraviolet to visible light region from a direction perpendicular to a substrate surface. The second one is intensity $I_0$ of omnidirectionally transmitted light transmitted from the opposite side of an incident surface when the surface of a substrate that has the same thickness and the same material as the substrate of the measurement sample and on which the metal-based particle assembly layer is not layered is irradiated with the same incident light from a direction perpendicular to the surface of the substrate. At this time, the absorbance, which is the vertical axis of the absorption spectrum, is represented by the following equation:

$$\text{Absorbance} = -\log_{10}(I/I_0).$$

The absorption spectrum can be measured using a general spectrophotometer.

In measuring the maximum wavelength of the plasmon peak on the longest wavelength side in the ultraviolet to visible light region and the absorbance thereof, absorption spectrum measurement may be performed by narrowing the measurement visual field using an objective lens and a spectrophotometer.

For ensuring that the metal-based particle assembly layer 20 has a plasmonic structure, the metal-based particles 21 are preferably including a material capable of plasmon resonance in the ultraviolet to visible light region. The material capable of plasmon resonance in the ultraviolet to visible light region means a material that exhibits a plasmon peak appearing in the ultraviolet to visible light region in absorption spectrum measurement by absorptiometry in the form of nanoparticles or assembly thereof.

Examples of the metal-based material capable of plasmon resonance in the ultraviolet to visible light region include noble metals such as gold, silver, copper, platinum, and palladium; metals other than noble metals, such as aluminum and tantalum; alloys containing a metal selected from the noble metals and the metals other than the noble metals; and metal compounds (such as metal oxides, and metal salts) containing a metal selected from the noble metals and the metals other than the noble metals. Among these materials, as the metal-based material capable of plasmon resonance in the ultraviolet to visible light region, a noble metal such as gold, silver, copper, platinum, or palladium is preferable, and silver is more preferable from the viewpoint of being inexpensive and having small absorption (a small imaginary part of a dielectric function at a visible light wavelength).

From the viewpoint of effectively obtaining the effects of [a] and [b], the plurality of metal-based particles 21 constituting the metal-based particle assembly layer 20 has an average particle diameter within a range of preferably 200 nm or more and 1600 nm or less, more preferably 200 nm or more and 1200 nm or less, still more preferably 250 nm or more and 500 nm or less, yet more preferably 300 nm or more and 500 nm or less. The average particle diameter of the metal-based particles 21 is preferably selected as appropriate in accordance with the type of the metal-based material constituting the metal-based particles 21.

The average particle diameter of the plurality of metal-based particles 21 is an average value of the particle diameters of ten selected metal-based particles, which is defined as follows. These ten metal-based particles are randomly selected from an SEM observation image captured from directly above the metal-based particle assembly layer 20 including the plurality of metal-based particles 21. In each metal-based particle image, five tangential diameters are randomly drawn (provided, however, that all straight line segments each serving as a tangential diameter are allowed to pass only through the inside of the metal-based particle image, and one of the straight line segments is a longest straight line segment that passes only through the inside of the metal-based particle image). The average value of these tangent diameters (hereinafter, this average value is also referred to as "average tangential diameter") is deemed as the particle diameter of each metal-based particle. The tangential diameter is defined as a perpendicular line segment with respect to two parallel lines, where the two parallel lines are in contact with and sandwich the outline (projection image) of the metal-based particle, and the length of the perpendicular line segment is a distance of the two parallel lines (the Nikkan Kogyo Shimbun, Ltd., "Particle Diameter Measurement Technique", 1994, page 5).

The method of measuring the average particle diameter will be more specifically described. First, the SEM observation image is obtained using a scanning electron microscope "JSM-5500" manufactured by JEOL Ltd., or an apparatus equivalent thereto. Next, the obtained observation image is read as 1280 pixels in width × 960 pixels in length by using free image processing software "ImageJ" manufactured by the National Institutes of Health. Subsequently, ten random numbers ($x_1$, $x_2$, $x_3$, $x_4$, $x_5$, $x_6$, $x_7$, $x_8$, $x_9$, $x_{10}$) are obtained from 1 to 1280, and ten random numbers ($y_1$, $y_2$, $y_3$, $y_4$, $y_5$, $y_6$, $y_7$, $y_8$, $y_9$, $y_{10}$) are obtained from 1 to 960 by using a random number generating function "RANDBETWEEN" of spreadsheet software "Excel" manufactured by Microsoft Corporation. Ten sets of random number combinations ($x_1$, $y_1$), ($x_2$, $y_2$), ($x_3$, $y_3$), ($x_4$, $y_4$), ($x_5$, $y_5$), ($x_6$, $y_6$), ($x_7$, $y_7$), ($x_8$, $y_8$), ($x_9$, $y_9$), and ($x_{10}$, $y_{10}$) are obtained from each of the obtained ten random numbers. Using the numerical value of the random number generated from 1 to 1280 as the x coordinate and the numerical value of the random number generated from 1 to 960 as the y coordinate, ten sets of coordinate points ($x_1$, $y_1$), ($x_2$, $y_2$), ($x_3$, $y_3$), ($x_4$, $y_4$), ($x_5$, $y_5$), ($x_6$, $y_6$), ($x_7$, $y_7$), ($x_8$, $y_8$), ($x_9$, $y_9$), and ($x_{10}$, $y_{10}$) are obtained. Then, the above-described average tangential diameter is obtained for each of a total of ten metal-based particle images including these coordinate points. Subsequently, the average particle diameter is obtained as an average value of the average tangential diameters of the ten metal-based particle images. When at least one of the ten coordinate points as ten sets of random number combinations is not included in the metal-based particle image, or when two or more coordinate points are included in the same metal-based particle image, this random number combination is discarded, and random number generation is repeated until all the ten coordinate points are respectively included in different metal-based particle images.

From the viewpoint of effectively obtaining the effects of [a] and [b], the plurality of metal-based particles 21 has an average height within a range of preferably 55 nm or more and 500 nm or less, more preferably 55 nm or more and 300 nm or less, still more preferably 70 nm or more and 150 nm or less. The average height of the metal-based particles 21 is an average value of ten measured values of heights of ten metal-based particles, where the ten metal-based particles are randomly selected and the heights of the ten metal-based particles are measured in an AFM observation image of the metal-based particle assembly layer 20.

From the viewpoint of effectively obtaining the effects of [a] and [b], the plurality of metal-based particles 21 has an aspect ratio within a range of preferably 1 or more and 8 or less, more preferably 2 or more and 8 or less, still more preferably 2.5 or more and 8 or less. The aspect ratio of the metal-based particles 21 is defined by the ratio of the average particle diameter to the average height (average particle diameter/average height). The metal-based particle 21 may have a perfect spherical shape, but preferably has a flat shape having an aspect ratio of more than 1 from the viewpoint of effectively obtaining the effects of [a] and [b].

From the viewpoint of effectively obtaining the effects of [a] and [b], each of the plurality of metal-based particles 21 in the metal-based particle assembly layer 20 is preferably disposed so that the average distance from one of the plurality of metal-based particles 21 to the adjacent metal-based particles (hereinafter, also referred to as an "average interparticle distance") is in the range of 1 nm or more and 150 nm or less. The plurality of metal-based particles 21 are disposed based on such an average interparticle distance, thereby making it easier to obtain strong plasmon resonance and further enhancing the effect of extending the range of effect of plasmon resonance.

From the viewpoint of effectively obtaining the effects of [a] and [b], the average interparticle distance is more preferably within a range of preferably 1 nm or more and 100 nm or less, still more preferably 1 nm or more and 50 nm or less, yet more preferably 1 nm or more and 20 nm or less. When the average interparticle distance is less than 1 nm, electron transfer between particles occurs based on a Dexter mechanism, which is disadvantageous in terms of deactivation of localized plasmon.

The average interparticle distance is an average value of interparticle distances of ten metal-based particles, where the ten metal-based particles are randomly selected from an SEM observation image captured from directly above the metal-based particle assembly layer 20 including the plurality of metal-based particles 21, and an interparticle distance between each selected metal-based particle and the adjacent metal-based particle thereof is determined. The interparticle distance between a metal-based particle and the adjacent metal-based particle thereof is a value obtained by measuring the distances between each selected metal-based particle and all the adjacent metal-based particles thereof (the minimum distances between the surfaces of the adjacent metal-based particles) and averaging these distances.

The method of measuring the average interparticle distance will be more specifically described. First, the SEM observation image is obtained by using the scanning electron microscope "JSM-5500" manufactured by JEOL Ltd., or an apparatus equivalent thereto. Next, the obtained observation image is read as 1280 pixels in width $\times$ 960 pixels in length by using free image processing software "ImageJ" manufactured by the National Institutes of Health. Next, ten random numbers ($x_1$ to $x_{10}$) are obtained from 1 to 1280, and ten random numbers ($y_1$ to $y_{10}$) are obtained from 1 to 960 by using a random number generating function "RANDBETWEEN" of spreadsheet software "Excel" manufactured by Microsoft Corporation. Ten sets of random number combinations ($x_1$, $y_1$) to ($x_{10}$, $y_{10}$) are obtained from each of the obtained ten random numbers. Using the numerical value of the random number generated from 1 to 1280 as the x coordinate and the numerical value of the random number generated from 1 to 960 as the y coordinate, ten sets of coordinate points ($x_1$, $y_1$) to ($x_{10}$, $y_{10}$) are obtained. Then, an interparticle distance between the metal-based particle and the adjacent metal-based particle is obtained for each of a total of ten metal-based particle images each including the coordinate point. Subsequently, an average interparticle distance is obtained as an average value of such ten interparticle distances. When at least one of the ten coordinate points as ten sets of random number combinations is not included in the metal-based particle image, or when two or more coordinate points are included in the same metal-based particle image, this random number combination is discarded, and random number generation is repeated until all the ten coordinate points are respectively included in different metal-based particle images.

From the viewpoint of effectively obtaining the effects of [a] and [b], each of the plurality of metal-based particles 21 in the metal-based particle assembly layer 20 is preferably disposed so that the standard deviation of the average interparticle distance described above is 35 nm or less. From the viewpoint of effectively obtaining the effects of [a] and [b], the standard deviation of the average interparticle distance is more preferably 30 nm or less. Further, the standard deviation thereof is preferably 0.1 nm or more, more preferably 0.2 nm or more, still more preferably 0.3 nm or more.

The standard deviation of the average interparticle distance is defined as follows. First, one metal-based particle is randomly selected from an SEM observation image captured from directly above the metal-based particle assembly layer 20 including the plurality of metal-based particles 21, and an interparticle distance between the selected metal-based particle and the adjacent metal-based particle thereof is determined. The interparticle distance between a metal-based particle and the adjacent metal-based particle thereof is a value obtained by measuring the distances between the selected metal-based particle and all the adjacent metal-based particles thereof (i.e., the minimum distances between the surfaces thereof) and averaging these distances. Then, in the above SEM observation image, nine metal-based particles different from the above one metal-based particle are randomly selected, and the interparticle distance between each of these nine metal-based particles and the respective adjacent metal-based particle is determined in the same manner as described above. The standard deviation of the interparticle distances between the total of ten metal-based particles thus obtained and the respective adjacent metal-based particles is defined as the standard deviation of the average interparticle distance.

The method of measuring the standard deviation of the average interparticle distance will be more specifically described. First, the SEM observation image is obtained by using the scanning electron microscope "JSM-5500" manufactured by JEOL Ltd., or an apparatus equivalent thereto. Next, the obtained observation image is read as 1280 pixels in width $\times$ 960 pixels in length by using free image processing software "ImageJ" manufactured by the National Institutes of Health. Next, ten random numbers ($x_1$ to $x_{10}$) are obtained from 1 to 1280, and ten random numbers ($y_1$ to $y_{10}$) are obtained from 1 to 960 by using a random number generating function "RANDBETWEEN" of spreadsheet software "Excel" manufactured by Microsoft Corporation. Ten sets of random number combinations ($x_1$, $y_1$) to ($x_{10}$, $y_{10}$) are obtained from each of the obtained ten random numbers. Using the numerical value of the random number generated from 1 to 1280 as the x coordinate and the numerical value of the random number generated from 1 to 960 as the y coordinate, ten sets of coordinate points ($x_1$, $y_1$) to ($x_{10}$, $y_{10}$) are obtained. Then, an interparticle distance between the metal-based particle and the adjacent metal-based particle is obtained for each of a total of ten metal-based particle images each including the coordinate point. Subsequently, the standard deviation of the average interparticle distance is obtained as the standard deviation of such ten interparticle distances. When at least one of the ten coordinate points as ten sets of random number combinations is not included in the metal-based particle image, or when two or more coordinate points are included in the same metal-based particle image, this random number combination is discarded, and random number generation is repeated until all the ten coordinate points are respectively included in different metal-based particle images.

From the viewpoint of exciting highly effective plasmon, the metal-based particle 21 preferably has a smooth curved surface, more preferably has a flat shape having a smooth curved surface, in particular. However, the metal-based particle 21 may have some minute irregularities (roughness) on the surface, and in this context, the metal-based particle may have an irregular shape.

The number of the metal-based particles 21 contained in the metal-based particle assembly layer 20 is generally ten or more, and preferably 30 or more. By forming the metal-based particle assembly layer containing ten or more metal-based particles, strong plasmon resonance and extension of the range of effect of plasmon resonance are easily exhibited by interaction between localized plasmons of the metal-based particles. The number of the metal-based particles 21 contained in the metal-based particle assembly layer 20 may be, for example, 50 or more, further 1000 or more, still further 10000 or more. The number density of the metal-based particles 21 in the metal-based particle assembly layer 20 is preferably 7 particles/$\mu$m$^2$ or more, more preferably 15 particles/$\mu$m$^2$ or more.

Preferably, the metal-based particle assembly layer 20 does not exhibit conductivity as the layer. More preferably, each of the metal-based particles 21 constituting the metal-based particle assembly layer 20 is non-conductive with the adjacent metal-based particles. When the metal-based particle assembly layer 20 has a portion where the metal-based particles 21 can give and receive electrons to and from each other, the plasmon resonance effect tends to be reduced. Therefore, the metal-based particles 21 are preferably surely spaced apart from each other, and a conductive substance is preferably not interposed between the metal-based particles 21. The metal-based particle 21 itself may have conductivity.

The feature of the metal-based particle assembly layer 20 not exhibiting conductivity as a layer can be confirmed by, for example, the following method. Specifically, a pair of tester probes of a multimeter [tester ("E2378A" manufactured by Hewlett-Packard Company)] is brought into contact with the metal-based particle assembly layer 20 while the testers are spaced at a distance of 10 mm to 15 mm. If the multimeter displays "Overload" as a result of the resistance value being 30 M$\Omega$ or more in the range setting of "30 M$\Omega$" under these measurement conditions, the metal-based particle assembly layer 20 does not exhibiting conductivity as a layer.

(3) Method of Manufacturing Metal-Based Particle Assembly Layer

The metal-based particle assembly layer 20 can be produced by, for example, the following method:

[A] a bottom-up method of growing a plurality of metal-based particles 21 from minute seeds on the base member 10;
[B] a method of covering a plurality of metal-based particles 21 with a protective film including an amphiphilic material having a predetermined thickness, and then transferring covered particles onto the base member 10 to form a film by the Langmuir Blodgett (LB) film method; and
[C] other methods including a method of post-processing a thin film produced by vapor deposition or sputtering, resist processing, etching processing, and a casting method using a dispersion liquid in which metal-based particles are dispersed.

The method [A] preferably includes a step of growing metal-based particles at a very low speed on the base member 10 adjusted to a predetermined temperature (hereinafter, this step is also referred to as a "particle growth step"). According to the manufacturing method including the particle growth step, the metal-based particle assembly layer 20 having the above-described preferable average particle diameter, average height, aspect ratio, average interparticle distance, and standard deviation of the average interparticle distance can be obtained in a well controlled manner.

In the particle growth step, the speed at which the metal-based particles are grown on the base member 10 is preferably less than 1 nm/min, and more preferably 0.5 nm/min or less in terms of average height growth rate. The average height growth rate as used herein can also be referred to as an average deposition rate or an average thickness growth rate of the metal-based particles, and can be defined by the following expression:
Average height of metal-based particles/metal-based particle growth time. The definition of the "average height of metal-based particles" is as described above.

The metal-based particle growth time refers to a time from the start to the end of the growth of the metal-based particles, and specifically refers to a supply time of the metal-based material. When the metal-based particle assembly layer 20 is regarded as a film, the metal-based particle growth time can also be referred to as a film formation time. When the method of growing the metal-based particles is the sputtering method, the metal-based particle growth time means a sputtering time.

The temperature of the base member 10 in the particle growth step is preferably 100°C or more and 450°C or less, more preferably 200°C or more and 450°C or less, still more preferably 250°C or more and 350°C or less, yet more preferably 300°C or the vicinity thereof (about 300°C ± 10°C).

Adjustment of factors such as the average height growth rate, the base member temperature, and/or the metal-based particle growth time makes it possible to control the average interparticle distance and the standard deviation thereof, the average particle diameter, the average height, and the aspect ratio of the plurality of metal-based particles 21 grown on the base member 10.

The pressure when the metal-based particles are grown (pressure in the apparatus chamber) is not particularly limited as long as the pressure can grow particles, but is generally less than atmospheric pressure. The lower limit of the pressure is not particularly limited, but is preferably 0.5 Pa or more, more preferably 6 Pa or more, and still more preferably 10 Pa or more because the average height growth rate can be easily adjusted within the above range.

A specific method of growing the metal-based particles on the base member 10 is not particularly limited as long as the method can grow particles at an average height growth rate of less than 1 nm/min. Examples of the method include a sputtering method and a vapor deposition method such as vacuum vapor deposition. Among the sputtering methods, a direct current (DC) sputtering method is preferably used because the metal-based particle assembly layer can be grown relatively easily, and an average height growth rate of less than 1 nm/min is easily maintained.

The sputtering method is not particularly limited, and a direct current argon ion sputtering method can be used. In this method, argon ions generated by an ion gun or plasma discharge are accelerated by an electric field, and a target is irradiated with the argon ions. Other conditions such as a current value, a voltage value, and a distance between the base member and the target in the sputtering method are appropriately adjusted so that the particles are grown at an average height growth rate of less than 1 nm/min.

In order to obtain the metal-based particle assembly layer 20 having the above-described preferable average particle diameter, average height, aspect ratio, average interparticle distance, and standard deviation of the average interparticle distance in a well controlled manner, the average particle diameter growth rate is preferably set to less than 5 nm in addition to setting the average height growth rate to less than 1 nm/min in the particle growth step. However, when the average height growth rate is less than 1 nm/min, the average particle diameter growth rate is generally less than 5 nm. The average particle diameter growth rate is more preferably 1 nm/min or less. The average particle diameter growth rate is defined as the following expression:
Average particle diameter of metal-based particles/metal-based particle growth time. The definitions of "average particle diameter of metal-based particles" and "metal-based particle growth time" are as described above.

In order to obtain the metal-based particle assembly layer 20 having the above-described preferable average particle diameter, average height, aspect ratio, average interparticle distance, and standard deviation of the average interparticle distance, it is preferable to appropriately adjust the metal-based particle growth time in the particle growth step while considering the above-described preferable manufacturing conditions.

(4) Base Member

The base member 10 is preferably including a non-conductive material. This is because the base member 10 including a conductive material tends to exhibit reduced plasmon resonance effect because metal-based particles formed thereon can give and receive electrons to and from each other. Examples of the non-conductive material constituting the base member 10 include inorganic insulating materials such as mica, $SiO_2$, $ZrO_2$, and glass, and thermoplastic resins. In the layered body including the base member 10, the metal-based particle assembly layer 20 is preferably directly layered on the base member 10.

The base member 10 may have a single layer structure or a multilayer structure. The shape of the base member 10 can be, for example, a plate shape, but may have a curved surface (e.g., granular shape). The plate-shaped base member 10 (substrate) preferably has a smooth surface, but may have surface irregularities or a curved surface. The base member 10 may be a base member having light-transmitting properties or being optically transparent, or may have non-light-transmitting properties (light absorbing properties).

The thickness of the base member 10 is not particularly limited, and is, for example, 10 μm or more and 10 mm or less, preferably 20 μm or more and 5 mm or less, more preferably 30 μm or more and 1 mm or less.

(5) Silicon Atom-Containing Layer

The silicon atom-containing layer 30 included in the layered body is a layer including a first surface. The first surface as used herein is at least a part of a surface defining the outer edge of the silicon atom-containing layer 30. In the layered body including the base member 10, the first surface is preferably at least a part of a surface opposite to the base member 10 side.

In the example of the layered body illustrated in Fig. 1, the silicon atom-containing layer 30 is disposed on the side opposite to the base member 10 with respect to the metal-based particle assembly layer 20 so as to cover the entire surface of the metal-based particle assembly layer 20 on the side opposite to the base member 10. From the viewpoint of protecting the metal-based particle assembly layer 20 or the like, the silicon atom-containing layer 30 is preferably disposed so as to cover the entire surface on the side opposite to the base member 10 in the metal-based particle assembly layer 20 in this manner. In other words, a part of the surface on the side opposite to the base member 10 in the layered body is preferably not constituted by the surface of the metal-based particle assembly layer 20. In the layered body illustrated in Fig. 1, the surface of the silicon atom-containing layer 30 on the side opposite to the base member 10 is a first surface 31, and the entire surface of the layered body on the side opposite to the base member 10 is constituted by the surface (first surface) of the silicon atom-containing layer 30. The silicon atom-containing layer 30 is preferably formed so as to fill gaps between the metal-based particles 21.

At the first surface 31 of the silicon atom-containing layer 30, the signal intensity of carbon atoms measured by X-ray photoelectron spectroscopy is 20.0 at.% or less. This allows the layered body to be made excellent in resistance to cleaning with a piranha solution. From the viewpoint of enhancing the resistance, the signal intensity of carbon atoms is preferably 18.0 at.% or less, more preferably 15.0 at.% or less, still more preferably 12.0 at.% or less, yet more preferably 10.0 at.% or less.

The signal intensity of carbon atoms is preferably 0.2 at.% or more, more preferably 0.5 at.% or more, still more preferably 1 at.% or more, and may be 5 at.% or more. In the case of forming the silicon atom-containing layer 30 having a too low signal intensity of carbon atoms, the selection of the forming process is necessary. Depending on this selection, the metal-based particle assembly layer 20 may be damaged during the formation. Specifically, for example, there may be no other choice but to employ a process requiring oxygen introduction and heating at a level that may damage the metal-based particle assembly layer 20. In the case of forming the silicon atom-containing layer 30 having a signal intensity of carbon atoms being not too low, a composition having a relatively high signal intensity of carbon atoms can be used as a silicon atom-containing layer-forming composition described below. By forming the silicon atom-containing layer 30 using such a composition, the coatability of the composition and the mass productivity of the layered body can be enhanced, and the smoothness of the surface of the silicon atom-containing layer 30 (surface opposite to the base member 10 side; the first surface) can be enhanced.

The signal intensity of carbon atoms at the first surface can be measured by X-ray photoelectron spectroscopy in accordance with the conditions described in the section of Examples described below. The signal intensity of carbon atoms is defined as a proportion (%) of the area of the signal of a carbon atom to the total area of all signals included in a spectrum acquired by X-ray photoelectron spectroscopy.

At the surface of the layered body on the side opposite to the base member 10, the signal intensity of atoms of the metal constituting the metal-based particle 21 as measured by X-ray photoelectron spectroscopy is preferably 7.0 at.% or less, more preferably 5.0 at.% or less, still more preferably 3.0 at.% or less, yet more preferably 2.0 at.% or less, particularly preferably 1.5 at.% or less, more particularly preferably 1.0 at.% or less, still more particularly preferably 0.7 at.% or less, and most preferably less than the detection limit. In this way, the metal-based particle assembly layer 20 can be more reliably protected, and the layered body can have excellent resistance to cleaning with a piranha solution. The signal intensity of atoms of the metal can be measured as a strength (at.%) of the metal atom signal observed from the surface, and is defined as a proportion (%) of the area of the signal of the metal atom to the total area of all signals included in a spectrum acquired by X-ray photoelectron spectroscopy.

The test for evaluating the resistance of the layered body to cleaning with a piranha solution is a cleaning test with a piranha solution in which the layered body is immersed in a piranha solution at a temperature of 25°C for 30 minutes. The piranha solution used in the cleaning test with a piranha solution is a mixed liquid obtained by mixing concentrated sulfuric acid having a concentration of 98 mass% and 30 mass% aqueous hydrogen peroxide solution at a volume ratio of 4 : 1.

The layered body excellent in the above resistance after the cleaning test with a piranha solution has no portion where the hole-shaped (pinhole-shaped) dissolution occurs in the metal-based particle assembly layer 20. If by any chance the layered body has such a portion, the number of the holes is small, or the diameter of the hole is small. In addition, the layered body excellent in the above resistance tends to have a surface roughness of the surface of the silicon atom-containing layer 30 (surface opposite to the base member 10 side; the first surface) that slightly changes before and after the cleaning test with a piranha solution. When the cleaning test with a piranha solution is performed on the layered body having very low resistance to cleaning with a piranha solution, the layered body may be corroded to such an extent that corrosion overreaches the metal-based particle assembly layer 20 under the silicon atom-containing layer 30.

The silicon atom-containing layer 30 may contain an oxygen (O) atom, a nitrogen (N) atom, and the like in addition to a silicon (Si) atom and a carbon (C) atom as an atom identifiable by X-ray photoelectron spectroscopy. Examples of a specific constituent material of the silicon atom-containing layer 30 include $Si_aO_bC_c$, $Si_dN_eC_f$, $Si_gO_hN_iC_j$, $Si_kO_l$, $Si_mN_n$, and $Si_oO_pN_q$, and $Si_aO_bC_c$, $Si_dN_eC_f$, and $Si_gO_hN_iC_j$ are preferable. a to q represent a composition ratio of each atom in each compound. The silicon atom-containing layer 30 may include two or more materials. The silicon atom-containing layer 30 may have a single-layer structure or a multilayer structure including different materials.

At the first surface 31 of the silicon atom-containing layer 30, a signal intensity of carbon atoms measured by X-ray photoelectron spectroscopy is, for example, 30 at.% or more and 90 at.% or less. From the viewpoint of enhancing the resistance of the layered body to cleaning with a piranha solution, the signal intensity of the oxygen atoms is preferably 40 at.% or more and 80 at.% or less, more preferably 50 at.% or more and 70 at.% or less, still more preferably 55 at.% or more and 65 at.% or less, particularly preferably 60 at.% or more and 65 at.% or less.

At the first surface 31 of the silicon atom-containing layer 30, the signal intensity of silicon atoms measured by X-ray photoelectron spectroscopy is, for example, 5 at.% or more and 50 at.% or less. From the viewpoint of enhancing the resistance of the layered body to cleaning with a piranha solution, the signal intensity of the silicon atoms is preferably 10 at.% or more and 45 at.% or less, more preferably 20 at.% or more and 40 at.% or less, still more preferably 25 at.% or more and 35 at.% or less.

The silicon atom-containing layer 30 is preferably an amorphous layer. According to the method of manufacturing a layered body described below, the silicon atom-containing layer 30 can be made as an amorphous layer despite including a step of performing heat treatment at a relatively high temperature. The silicon atom-containing layer 30 being an amorphous layer has the advantage that a material to which a coating process can be applied can be selected as a raw material of the silicon atom-containing layer 30, and production with an industrially high throughput can be conducted.

It can be confirmed by an X-ray diffraction method that the silicon atom-containing layer 30 is an amorphous layer. That is, it can be determined that the silicon atom-containing layer 30 is an amorphous layer on the basis of the absence of a peak at which the full width at half maximum (FWHM) derived from a crystal is 5° or less in the range of $2\theta = 5°$ to 85° (preferably in the range of 0° to 90°) when the silicon atom-containing layer 30 is measured by an X-ray diffraction method in accordance with the conditions described in the section of Examples described below.

The average thickness of the silicon atom-containing layer 30 is generally 10 nm or more and 300 nm or less, preferably 15 nm or more and 250 nm or less, more preferably 20 nm or more and 200 nm or less. The average thickness of the silicon atom-containing layer 30 may be 30 nm or more, 40 nm or more, 50 nm or more, 55 nm or more, or 60 nm or more. The silicon atom-containing layer 30 having an average thickness in the above range can sufficiently impart the function of protecting the metal-based particle assembly layer 20 and the durability of the layered body, and can lead to planarization of surface irregularities of the metal-based particle assembly layer 20.

By using the metal-based particle assembly layer exhibiting the characteristics [a] and [b] as the metal-based particle assembly layer 20, the effect of plasmon resonance by the metal-based particle assembly layer 20 (e.g., the emission enhancing effect of the luminescent substance) can be obtained while sufficiently imparting the function of protecting the metal-based particle assembly layer 20 and the durability of the layered body in the case of layering the silicon atom-containing layer 30 having an average thickness of 10 nm or more.

The silicon atom-containing layer 30 preferably has an average thickness in the above range and has a thickness so as to cover the entire surface of the metal-based particle assembly layer 20 on the side opposite to the base member 10. It can be confirmed that the silicon atom-containing layer 30 covers the entire surface of the metal-based particle assembly layer 20 on the side opposite to the base member 10 by acquiring a surface image of the layered body using the scanning electron microscope "JSM-5500" manufactured by JEOL Ltd., or an apparatus equivalent thereto. Alternatively, similarly to the measurement of the signal intensity of carbon atoms at the first surface, this can be confirmed also by measuring the surface of the layered body on the side opposite to the base member 10 by X-ray photoelectron spectroscopy, and checking whether the signal intensity of atoms of the metal constituting the metal-based particles 21 is 2.0 at.% or less.

In a case where the silicon atom-containing layer 30 covers the entire surface of the metal-based particle assembly layer 20 on the side opposite to the base member 10, the signal intensity of atoms of the metal constituting the metal-based particles 21 on the surface of the layered body on the side opposite to the base member 10, as measured by X-ray photoelectron spectroscopy, is preferably 1.5 at.% or less, more preferably 1.0 at.% or less, still more preferably 0.7 at.% or less, particularly preferably less than the detection limit.

The average thickness of the silicon atom-containing layer 30 is measured in accordance with the following method. A sectional image of the layered body is acquired using the scanning electron microscope "JSM-5500" manufactured by JEOL Ltd., or an apparatus equivalent thereto. In the obtained sectional image, ten points on the surface of the metal-based particle assembly layer 20, which form an interface with the silicon atom-containing layer 30, are randomly selected. Then, shortest straight line segments are drawn from each of the ten points to the outer surface (first surface 31) of the silicon atom-containing layer 30, and an average value of lengths of the obtained ten straight line segments is deemed as the average thickness of the silicon atom-containing layer 30.

The silicon atom-containing layer 30 is preferably a wet coating layer. The wet coating layer refers to a layer formed through a step of applying a coating liquid (silicon atom-containing layer-forming composition described later). The silicon atom-containing layer 30 being a wet coating layer has an advantage in smoothing the surface of the silicon atom-containing layer 30 (surface opposite to the base member 10 side; the first surface). The silicon atom-containing layer 30 being a wet coating layer makes it easier to obtain a layered body including the silicon atom-containing layer 30 having a small roughness of the surface (surface opposite to the base member 10 side; the first surface). In a case where subsequent processing such as coating is performed on the surface, a small surface roughness of the silicon atom-containing layer 30 facilitates improving the uniformity of the processing in the subsequent processing and reducing failures due to the occurrence of defects or the like associated with the subsequent processing.

Note that the silicon atom-containing layer 30 may be formed by a vapor deposition method, a sputtering method, a CVD method, or the like. In this case, however, the obtained silicon atom-containing layer 30 tends to be a layer having surface irregularities (having large surface roughness) following the surface irregularities of the metal-based particle assembly layer 20, and tends to be a crystalline silicon atom-containing layer 30.

An arithmetic mean roughness Ra of the surface of the silicon atom-containing layer 30 (surface opposite to the base member 10 side; the first surface) measured in conformity with JIS B 0601:2001 [hereinafter, this arithmetic mean roughness Ra is also referred to as "Ra (before test)"] is preferably 10 nm or less, more preferably 8 nm or less, still more preferably 5 nm or less, yet more preferably 3 nm or less, particularly preferably 2 nm or less. Ra (before test) may be 0.1 nm or more.

The layered body according to the present invention is excellent in resistance to cleaning with a piranha solution. An arithmetic mean roughness Ra of the layered body measured after the cleaning test with a piranha solution in conformity with JIS B 0601:2001 [hereinafter, this arithmetic mean roughness Ra is also referred to as "Ra (after test)"] is preferably 15 nm or less, more preferably 10 nm or less, still more preferably 8 nm or less, yet more preferably 5 nm or less, particularly preferably 3 nm or less, more particularly preferably 2 nm or less. Ra (after test) may be 0.1 nm or more.

In the layered body according to the present invention, Ra (before test) may be 10 nm or less, 8 nm or less, 5 nm or less, 3 nm or less, or 2 nm or less, and Ra (after test) may be 10 nm or less, 8 nm or less, 5 nm or less, 3 nm or less, or 2 nm or less. In addition, the layered body according to the present invention tends to have a surface roughness of the surface of the silicon atom-containing layer 30 (surface opposite to the base member 10 side; the first surface) that slightly changes before and after the test.

<Sensor Element>

The layered body can be used for a sensor element mounted on a sensor apparatus for detecting an analyte. For example, after the layered body is cleaned with a piranha solution, a capturing substance that specifically binds to an analyte is introduced into a predetermined position on the surface of the silicon atom-containing layer 30 (surface opposite to the base member 10 side; the first surface) by using a photolithography method or the like. As a result, the sensor element can be obtained.

The sensor element can detect an analyte, for example, as follows. The detection may be qualitative or quantitative detection, and refers to, for example, identification or quantification of an analyte. When the labeled analyte specifically bound to the capturing substance included in the sensor element is irradiated with excitation light, the label as a luminescent substance is excited. Then, the metal-based particle assembly layer of the sensor element, which is preferably a plasmonic structure, resonates with the excited luminescent substance, and plasmon luminescence enhancement is exhibited. The analyte can be qualitatively or quantitatively detected by using a detector and detecting emission from the excited luminescent substance. For example, the abundance of the analyte can be qualitatively or quantitatively measured by measuring the luminescence intensity.

With the sensor element including the layered body according to the present invention, detection sensitivity and detection accuracy can be improved the layered body includes a metal-based particle assembly layer which is preferably a plasmonic structure, and thus plasmon emission enhancement can be exhibited.

The analyte is a substance to be qualitatively or quantitatively detected, and is a substance that specifically binds to the capturing substance. The analyte is not particularly limited, and examples thereof include nucleosides, nucleotides, nucleic acids, proteins, saccharides, glycoproteins, lectins, viruses, cells, antibodies, and exosomes. A sensor element capable of detecting a substance derived from or relating to a living body is also referred to as a biosensor element.

The nucleic acid means a polymer of a phosphate of a nucleoside in which a purine base or a pyrimidine base and a sugar are glycosidically linked (nucleotide chain). The nucleic acid includes an oligonucleotide including a probe DNA, a polynucleotide, DNA obtained by polymerizing a purine nucleotide and a pyrimidine nucleotide (full length or a fragment thereof), RNA, and a polyamide nucleotide derivative (PNA). In addition, nucleoside is a compound in which a base and a sugar are glycosidically linked, nucleotide is a compound in which phosphoric acid is linked to nucleoside, and nucleoside and nucleotide are compounds containing a base.

The term "specifically binding" broadly means chemical bonding including non-covalent bonding, covalent bonding, and hydrogen bonding between substances, and examples thereof include an interaction between protein molecules and an electrostatic interaction between molecules.

The captured analyte can be detected by labeling in advance the analyte with a label as a luminescent substance and detecting light emission from the label. The label may be a labeling substance that specifically binds to a complex obtained by specific binding between the capturing substance and the analyte. The luminescent substance is a substance that emits light by injecting excitation energy generated by excitation light. The principle of light emission of the luminescent substance is not limited, and examples thereof include fluorescence, phosphorescence, and chemiluminescence. As the luminescent substance, a light emitter known in the related art can be used.

The capturing substance is a substance that specifically binds to an analyte and functions to capture the analyte. The capturing substance is, for example, fixed to the surface of the silicon atom-containing layer 30. The capturing substance is, for example, a substance having a binding active group that specifically binds to an analyte. Examples of the binding active group include a carboxyl group and a hydroxyl group that can electrostatically interact with an analyte. The capturing substance is not particularly limited, and examples thereof include nucleosides, nucleotides, nucleic acids, proteins, saccharides, and glycoproteins.

Examples of the sensor apparatus include biosensor apparatuses such as a DNA sequencer, a DNA microarray, a virus sensor, an ion sensor, a plate reader (such as protein chip, glycochip, lectin chip), a microspectrometer, and a glucose sensor.

<Method of Manufacturing layered body>

The present invention provides a method of manufacturing a layered body. The layered body includes a metal-based particle assembly layer including a plurality of metal-based particles disposed apart from each other, and a silicon atom-containing layer. The silicon atom-containing layer includes a first surface, and the signal intensity of carbon atoms at the first surface as measured by X-ray photoelectron spectroscopy is 20.0 at.% or less. The description in the section of <Layered Body> is cited for the specific structure, the base member, the metal-based particle assembly layer, the materials of the metal-based particles and the silicon atom-containing layer, and the like of the layered body obtained by the manufacturing method described herein. The method of manufacturing a layered body according to the present invention is suitable as the method of manufacturing a layered body described in the section of <Layered Body>.

A method of manufacturing a layered body according to the present invention includes forming the metal-based particle assembly layer on a base member, forming a coating layer by applying a silicon atom-containing layer-forming composition onto a base member on which a metal-based particle assembly layer is formed, and heat-treating the coating layer at a temperature of 300°C or more and 800°C or less.

The step of forming the metal-based particle assembly layer can be performed, for example, in accordance with the method of manufacturing a metal-based particle assembly layer described in the section of <Layered Body>.

In the step of forming the coating layer, the silicon atom-containing layer-forming composition is applied onto the base member on which the metal-based particle assembly layer is formed. The use of such a coating method can facilitate the formation of a silicon atom-containing layer having a desired average thickness and a smooth surface. Examples of the coating method include a spin coating method, a slit coating method, and a slit-and-spin coating method.

The silicon atom-containing layer-forming composition contains a substance that can form a silicon atom-containing layer including, for example, the materials exemplified above (silicon atom-containing layer-forming component) by the step of heat-treating the coating layer. Examples of the substance include silicon atom-containing substances such as spin-on-glass (SOG), polysilazane, tetraethyl orthosilicate (TEOS), and methyltrimethoxysilane (MTMS). The spin-on-glass (SOG) has a siloxane structure, and examples thereof include silica glass, alkyl siloxane polymers, alkyl silsesquioxane polymers, hydrogenated silsesquioxane polymers, and hydrogenated alkyl silsesquioxane polymers.

Among them, from the viewpoint of forming a silicon atom-containing layer having the above-described preferable lower limit value or more of the signal intensity of carbon atoms, the silicon atom-containing layer-forming composition preferably contains a silicon atom-containing layer-forming component having a carbon atom, such as an organic SOG having an organic group or an organic structure. Examples of the organic SOG include SOG having a methyl group or an ethyl group. The use of the organic SOG can also improve the coatability of the silicon atom-containing layer-forming composition.

The silicon atom-containing layer-forming composition may further contain a solvent, a reaction catalyst, water, a surfactant, and the like in addition to the silicon atom-containing layer-forming component.

After the coating layer is formed, a step of heat-treating the coating layer at a temperature of 300°C or more and 800°C or less is performed. The temperature of the heat treatment is preferably 350°C or more and 700°C or less, more preferably 400°C or more and 650°C or less, still more preferably 450°C or more and 600°C or less, and particularly preferably 500°C or more and 600°C or less. In the case of using the silicon atom-containing layer-forming component having a carbon atom, a too low heat treatment temperature tends to make the signal intensity of carbon atoms in the silicon atom-containing layer 30 larger than a preferable range. In this case, the resistance of the layered body to cleaning with a piranha solution is low. A too high heat treatment temperature may oxidize the metal-based particle assembly layer 20 and exceed the decomposition temperature of the oxidized metal-based particles or the melting temperature of the metal-based particle assembly layer. In this case, the metal-based particle assembly layer 20 may be damaged in the heat treatment step.

The time of the heat treatment is, for example, one minute or more and 720 minutes or less, preferably two minutes or more and 480 minutes or less, and more preferably two minutes or more and 240 minutes or less. Heat treatment can be performed, for example, in air or in an inert gas (e.g., nitrogen, argon) atmosphere. The pressure of the heat treatment may be normal pressure.

The method of manufacturing a layered body can further include a step of degreasing and cleaning the base member before the step of forming the metal-based particle assembly layer. By further including this step, the resistance of the obtained layered body to cleaning with a piranha solution can be further enhanced. As the degreasing and cleaning of the base member, an appropriate method can be adopted depending on the material of the base member, and examples thereof include cleaning using a liquid selected from organic solvents and water. Examples of the cleaning method include a method of immersing the base member in the liquid, a method of ultrasonically cleaning the base member while immersing the base member in the liquid, and a method of wiping the base member with a cloth (such as woven cloth and non-woven cloth) impregnated with the liquid.

Degreasing and cleaning may be a combination of cleaning steps using two or more liquids. For example, when the base member is a glass substrate, degreasing and cleaning can include ultrasonic cleaning using alcohols (such as methyl alcohol, ethyl alcohol, and isopropyl alcohol), ultrasonic cleaning using ketones (such as acetone, methyl ethyl ketone, methyl isobutyl ketone), and ultrasonic cleaning using ultrapure water, which are performed in this order.

Examples

Hereinafter, the present invention will be described in more detail with reference to examples, but the present invention is not limited to these examples.

<Example 1>

(1) Degreasing and Cleaning of Glass Substrate

A soda glass substrate having a 5 cm-side square shape and a thickness of 0.7 mm was prepared. This soda glass substrate was subjected to cleaning with isopropyl alcohol, cleaning with acetone, and then washing with ultrapure water as degreasing and cleaning treatment.

(2) Formation of Metal-Based Particle Assembly Layer

Silver particles were very slowly grown on the soda glass substrate subjected to a degreasing and cleaning treatment using a direct current magnetron sputtering apparatus under the following conditions, and thus a metal-based particle assembly layer was formed on the entire surface of the substrate surface.

Gas Used: Argon
In-Chamber Pressure (Sputtering Gas Pressure): 10 Pa
Distance between substrate and target: 100 mm
Sputtering Power: 4W
Average Particle Diameter Growth Rate (Average Particle Diameter/Metal-Based Particle Growth Time): 0.9 nm/min
Average Height Growth Rate (= Average Deposition Rate = Average Height/Metal-Based Particle Growth Time): 0.25 nm/min
Substrate Temperature: 300°C
Metal-Based Particle Growth Time: 360 min

Figs. 2A and 2B are SEM images of the metal-based particle assembly layer formed on the substrate as viewed from directly above. Fig. 2A is a magnified image on a scale of 10000x, and Fig. 2B is a magnified image on a scale of 50000x. The scanning electron microscope "JSM-5500" manufactured by JEOL Ltd. was used to acquire the SEM images.

From the SEM images provided in Figs. 2A and 2B, the average particle diameter, the average interparticle distance, and the standard deviation of the average interparticle distance, all of which were based on the above-described definitions, of the silver particles constituting the metal-based particle assembly layer were determined to be 335 nm, 16.7 nm, and 27.8 nm, respectively. As can be seen from the SEM images, the metal-based particle assembly layer includes about $6.25 \times 10^{10}$ (about 25 particles/$\mu$m$^2$) of silver particles. In addition, the average height of the silver particles was determined to be 96.2 nm on the basis of the result of AFM image photographing using "VN-8010" manufactured by KEYENCE CORPORATION. Therefore, the aspect ratio (average particle diameter/average height) of the silver particles was calculated to be 3.48. Fig. 3 provides an AFM image of the metal-based particle assembly layer. The size of the image provided in Fig. 3 is 5 $\mu$m $\times$ 5 $\mu$m.

Conductivity was checked by connecting a tester [multimeter ("E2378A" manufactured by Hewlett-Packard Company)] to the surface of the metal-based particle assembly layer formed on the substrate. As a result, non-conductivity was confirmed.

(3) Formation of Silicon Atom-Containing Layer

A coating layer was formed by spin-coating the silicon atom-containing layer-forming composition on the metal-based particle assembly layer formed on the substrate. Next, the intermediate layered body including the substrate/metal-based particle assembly layer/coating layer was introduced into a drying furnace and heat-treated in air at 550°C and normal pressure for 30 minutes, and a layered body including the substrate/metal-based particle assembly layer/silicon atom-containing layer, which is the configuration illustrated in Fig. 1 was obtained. As the silicon atom-containing layer-forming composition, a composition obtained by diluting "OCD T-7 5500T" manufactured by TOKYO OHKA KOGYO CO., LTD. as an organic SOG material with ethanol was used.

(4) Analysis of Silicon Atom-Containing Layer and Evaluation of Layered Body

(4-1) Covered State of Metal-Based Particle Assembly Layer with Silicon Atom-Containing Layer and Average Thickness of Silicon Atom-Containing Layer

The layered body was cut along a plane parallel to the layering direction of layers, and a sectional image of the cut portion was observed using the scanning electron microscope "JSM-5500" manufactured by JEOL Ltd. In this manner, it was confirmed that the silicon atom-containing layer covered the entire surface of the metal-based particle assembly layer on the side opposite to the glass substrate. In addition, the surface of the layered body on the side opposite to the glass substrate was measured by X-ray photoelectron spectroscopy by using the apparatus and under measurement conditions described below, and no signal of silver atoms was detected. This also contributed to confirmation that the silicon atom-containing layer covered the entire surface of the metal-based particle assembly layer on the side opposite to the glass substrate. It was also confirmed that the silicon atom-containing layer was formed not only on the surface of the silver particles of the metal-based particle assembly layer but also in gaps between the silver particles.

Furthermore, the average thickness of the silicon atom-containing layer based on the above measurement method using the scanning electron microscope "JSM-5500" manufactured by JEOL Ltd. was 87.0 nm.

(4-2) Signal Intensity of Atoms Constituting First Surface

The intensity (at.%) of atomic signals observed from the first surface (surface of the layered body on the side opposite to the glass substrate) of the silicon atom-containing layer was determined by X-ray photoelectron spectroscopy using the following apparatus in accordance with the following measurement conditions. The signal intensity of each atom is defined as a proportion (%) of the area of the signal of each atom to the total area of all signals included in a spectrum acquired by X-ray photoelectron spectroscopy. The proportion (%) of the area of the signal of each atom was measured at any three points at the first surface, and the average value of these measured values was deemed as the intensity of the atomic signal thereof. The atoms identified by X-ray photoelectron spectroscopy were C, O, and Si. Signal intensities thereof are listed below.

    C: 8.8 at.%
    O: 61.9 at.%
    Si: 29.3 at.%

(Apparatus and Measurement Conditions)

- Apparatus: K-Alpha X-ray photoelectron spectroscopy system manufactured by Thermo Fisher Scientific Inc.
- Measurement Range: 400 $\times$ 800 mm
- Elements Measured (Number of Scans): O (4), C (4), Si (4)
- Dwell Time: 50 ms
- Neutralizing Gun: Yes
- GCIB: Yes (for decontamination of surface)

(4-3) Crystallinity of Silicon Atom-Containing Layer

The X-ray diffraction (XRD) spectrum of the first surface (surface of the layered body on the side opposite to the glass substrate) of the silicon atom-containing layer was acquired by X-ray diffraction method using the following apparatus in accordance with the following measurement conditions. It was confirmed that the silicon atom-containing layer was an amorphous layer on the basis of absence of a peak having a full width at half maximum (FWHM) of 5° or less over the entire range of $2\theta$.

(Apparatus and Measurement Conditions)

- Apparatus: SmartLab manufactured by Rigaku Corporation
- Measurement Method: $\theta/2\theta$ measurement method
- Measurement Range: $2\theta = 5°$ to $90°$
- Tube Voltage: 45 kV
- Tube Current: 200 mA

(4-4) Arithmetic Mean Roughness Ra (Before Test) of First Surface

The arithmetic mean roughness Ra of the first surface of the silicon atom-containing layer in the obtained layered body measured in conformity with JIS B 0601:2001 was 1.5 nm.

(4-5) Arithmetic Mean Roughness Ra (After Test) of First Surface

The obtained layered body was subjected to a cleaning test with a piranha solution in which the layered body was immersed in a piranha solution at a temperature of 25°C for 30 minutes. The piranha solution used is a mixed liquid obtained by mixing concentrated sulfuric acid having a concentration of 98 mass% and 30 mass% aqueous hydrogen peroxide solution at a volume ratio of 4 : 1. After the test, the arithmetic mean roughness Ra of the first surface at any one point measured in conformity with JIS B 0601:2001 as in (4-4) was 2.0 nm.

(4-6) Evaluation of Resistance of Layered Body to Cleaning with Piranha Solution

When the first surface of the silicon atom-containing layer in the layered body after the cleaning test with a piranha solution described in (4-5) was observed with an optical microscope, the surface texture was equivalent to that before the test.

<Example 2>

A layered body including the substrate/metal-based particle assembly layer/silicon atom-containing layer, which was the configuration illustrated in Fig. 1, was obtained in the same manner as in Example 1 except that the temperature of the heat treatment performed after forming the coating layer of the silicon atom-containing layer-forming composition was 400°C. For the obtained layered body, analysis of the silicon atom-containing layer and evaluation of the layered body were performed in the same manner as in (4) of Example 1.

Also in the present example, it was confirmed that the silicon atom-containing layer covered the entire surface of the metal-based particle assembly layer on the side opposite to the glass substrate from both observation of a sectional image using the scanning electron microscope "JSM-5500" and measurement by X-ray photoelectron spectroscopy. The average thickness of the silicon atom-containing layer was 138.1 nm.

When the first surface of the silicon atom-containing layer was measured by X-ray photoelectron spectroscopy, the identified atoms were C, O, Si, and Ag. Signal intensities thereof are listed below.

C: 11.7 at.%
O: 58.4 at.%
Si: 29.1 at.%
Ag: 0.8 at.%

It was confirmed from the XRD spectrum of the first surface of the silicon atom-containing layer that the silicon atom-containing layer was an amorphous layer.

The measured arithmetic mean roughness Ra (before test) of the first surface of the silicon atom-containing layer was 2.1 nm. The measured arithmetic mean roughness Ra (after test) of the first surface was 4.0 nm. When the first surface of the silicon atom-containing layer in the layered body after the cleaning test with a piranha solution was observed with an optical microscope, there was a few dissolved portions that had a very small hole shape.

<Example 3>

A layered body including the substrate/metal-based particle assembly layer/silicon atom-containing layer, which was the configuration illustrated in Fig. 1, was obtained in the same manner as in Example 2 except that the glass substrate was not degreased and cleaned. For the obtained layered body, analysis of the silicon atom-containing layer and evaluation of the layered body were performed in the same manner as in (4) of Example 1.

Also in the present example, it was confirmed that the silicon atom-containing layer covered the entire surface of the metal-based particle assembly layer on the side opposite to the glass substrate from both observation of a sectional image using the scanning electron microscope "JSM-5500" and measurement by X-ray photoelectron spectroscopy. The average thickness of the silicon atom-containing layer was 138.1 nm.

When the first surface of the silicon atom-containing layer was measured by X-ray photoelectron spectroscopy, the identified atoms were C, O, Si, and Ag. Signal intensities thereof are listed below.

C: 10.1 at.%
O: 59.6 at.%
Si: 29.2 at.%
Ag: 1.1 at.%

It was confirmed from the XRD spectrum of the first surface of the silicon atom-containing layer that the silicon atom-containing layer was an amorphous layer.

The measured arithmetic mean roughness Ra (before test) of the first surface of the silicon atom-containing layer was 2.1 nm. The measured arithmetic mean roughness Ra (after test) of the first surface was 13.3 nm. When the first surface of the silicon atom-containing layer in the layered body after the cleaning test with a piranha solution was observed with an optical microscope, there were a few dissolved portions that had a small hole shape.

<Comparative Example 1>

A layered body including the substrate/metal-based particle assembly layer/silicon atom-containing layer, which was the configuration illustrated in Fig. 1, was obtained in the same manner as in Example 1 except that the glass substrate was not degreased and cleaned as well as the temperature of the heat treatment performed after forming the coating layer of the silicon atom-containing layer-forming composition was 200°C. For the obtained layered body, analysis of the silicon atom-containing layer and evaluation of the layered body were performed in the same manner as in (4) of Example 1.

Also in the present comparative example, it was confirmed that the silicon atom-containing layer covered the entire surface of the metal-based particle assembly layer on the side opposite to the glass substrate from both observation of a sectional image using the scanning electron microscope "JSM-5500" and measurement by X-ray photoelectron spectroscopy. The average thickness of the silicon atom-containing layer was 142.2 nm.

When the first surface of the silicon atom-containing layer was measured by X-ray photoelectron spectroscopy, the identified atoms were C, O, and Si, and the signal intensities thereof were as follows.

C: 20.7 at.%
O: 51.5 at.%
Si: 27.8 at.%

It was confirmed from the XRD spectrum of the first surface of the silicon atom-containing layer that the silicon atom-containing layer was an amorphous layer.

The measured arithmetic mean roughness Ra (before test) of the first surface of the silicon atom-containing layer was 1.5 nm. When the first surface of the silicon atom-containing layer in the layered body after the cleaning test with a piranha solution was observed with an optical microscope, there was a portion where the silicon atom-containing layer disappeared due to dissolution and the metal-based particle assembly layer thereunder also disappeared due to dissolution.

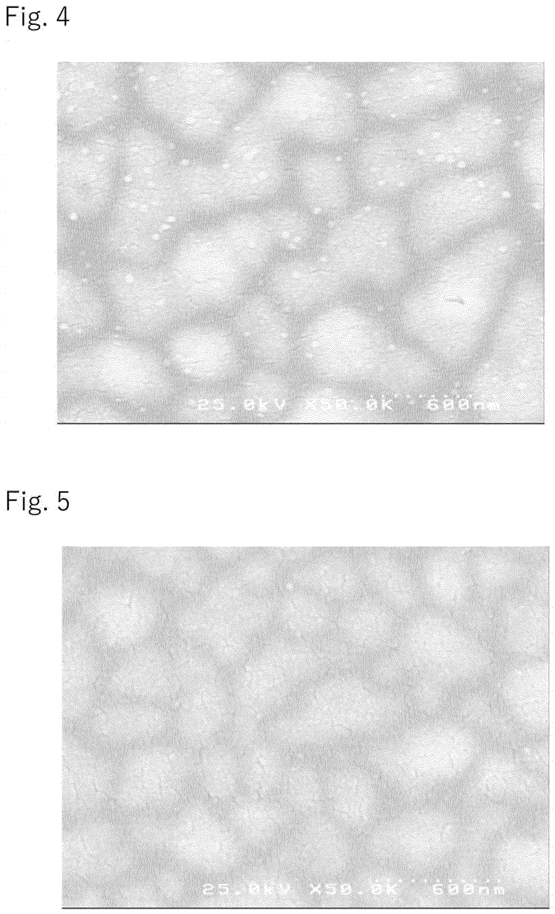

Fig. 4 is an SEM image of the layered body of Example 1 before the cleaning test with a piranha solution as viewed from the silicon atom-containing layer side, and Fig. 5 is an SEM image of the layered body of Example 1 after the cleaning test with a piranha solution as viewed from the silicon atom-containing layer side. Both are magnified images on a scale of 50000x. The scanning electron microscope "JSM-5500" manufactured by JEOL Ltd. was used to acquire the SEM images. It can be confirmed that there is almost no change in surface texture before and after the cleaning test with a piranha solution.

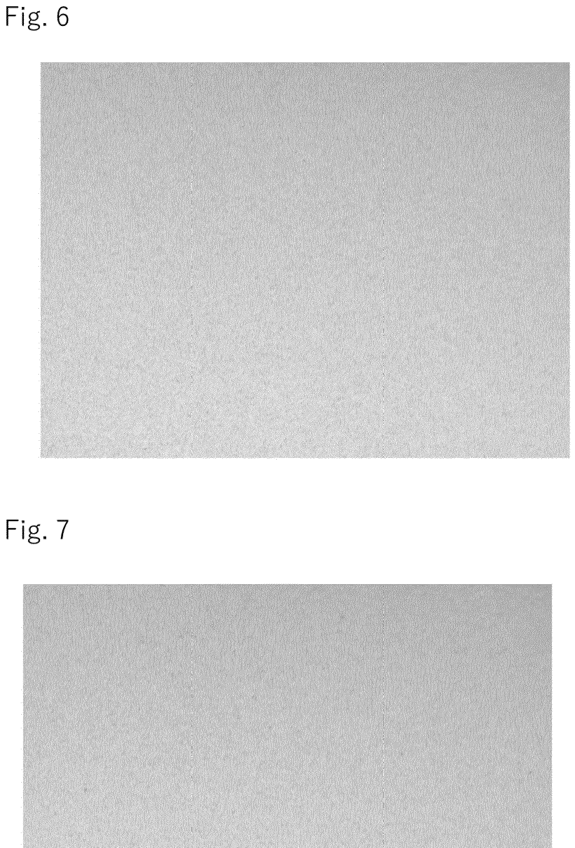

Each of Figs. 6 to 10 is an optical microscope image (700x) when a corresponding one of the following layered bodies is viewed from the silicon atom-containing layer side.

Fig. 6: Layered body of Example 1 before cleaning test with piranha solution

Fig. 7: Layered body of Example 1 after cleaning test with piranha solution

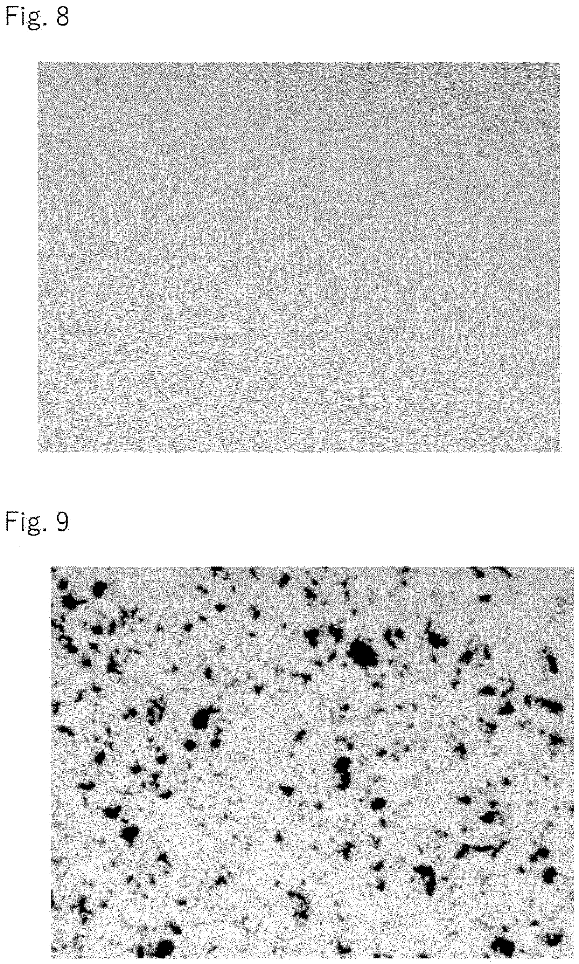

Fig. 8: Layered body of Example 2 after cleaning test with piranha solution

Fig. 9: Layered body of Example 3 after cleaning test with piranha solution

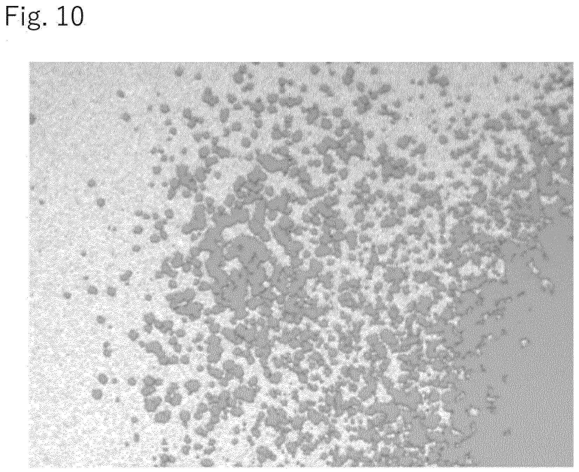

Fig. 10: Layered body of Comparative Example 1 after cleaning test with piranha solution

**Claims**

1.  A layered body comprising:

    a metal-based particle assembly layer including a plurality of metal-based particles disposed apart from each other; and
    a silicon atom-containing layer,
    wherein the silicon atom-containing layer includes a first surface, and
    the first surface has a signal intensity of carbon atoms of 20.0 at.% or less, the signal intensity being measured by X-ray photoelectron spectroscopy.

2.  The layered body according to claim 1, comprising:

    a base member;
    the metal-based particle assembly layer being disposed on a surface of the base member; and
    the silicon atom-containing layer being disposed on the metal-based particle assembly layer,
    wherein the silicon atom-containing layer covers an entire surface of the metal-based particle assembly layer on a side opposite to the base member.

3.  The layered body according to claim 1 or 2, wherein the silicon atom-containing layer is an amorphous layer.

4. The layered body according to claim 1 or 2, wherein the silicon atom-containing layer is a wet coating layer.

5. The layered body according to claim 1 or 2, wherein the silicon atom-containing layer has an average thickness of 10 nm or more and 300 nm or less.

6. The layered body according to claim 1 or 2, wherein the plurality of metal-based particles comprise silver.

7. The layered body according to claim 1 or 2, wherein

the plurality of metal-based particles have
an average particle diameter within a range of 200 nm or more and 1600 nm or less,
an average height within a range of 55 nm or more and 500 nm or less, and
an aspect ratio within a range of 1 or more and 8 or less, the aspect ratio being defined as a ratio of the average particle diameter to the average height, and
each of the plurality of metal-based particles in the metal-based particle assembly layer is disposed based on an average distance from an adjacent metal-based particle among the plurality of metal-based particles within a range of 1 nm or more and 150 nm or less.

8. The layered body according to claim 7, wherein the aspect ratio is greater than 1.

9. The layered body according to claim 1 or 2, wherein the first surface has an arithmetic mean roughness Ra of 10 nm or less, the arithmetic mean roughness being measured in conformity with JIS B 0601: 2001.

10. The layered body according to claim 1 or 2, wherein the first surface has an arithmetic mean roughness Ra of 15 nm or less, the arithmetic mean roughness Ra being measured in conformity with JIS B 0601: 2001 after immersion for 30 minutes in a mixed liquid at a temperature of 25°C, the mixed liquid being obtained by mixing concentrated sulfuric acid having a concentration of 98 mass% and 30 mass% aqueous hydrogen peroxide solution at a volume ratio of 4 : 1.

11. A method of manufacturing a layered body,

the layered body including

a metal-based particle assembly layer including a plurality of metal-based particles being disposed apart from each other, and

a silicon atom-containing layer,

the silicon atom-containing layer having a first surface, and
the first surface having a signal intensity of carbon atoms of 20.0 at.% or less, the signal intensity being measured by X-ray photoelectron spectroscopy,
the method comprising:

forming the metal-based particle assembly layer on a base member;
forming a coating layer by applying a silicon atom-containing layer-forming composition onto the base member on which the metal-based particle assembly layer is formed; and
heat-treating the coating layer at a temperature of 300°C or more and 800°C or less.

12. The method according to claim 11, further comprising degreasing and cleaning the base member before the step of forming the metal-based particle assembly layer.

Fig. 1

Fig. 2

(a)

(b)

Magnified

Fig. 3

Fig. 4

Fig. 5

Fig. 6

Fig. 7

Fig. 8

Fig. 9

Fig. 10

## INTERNATIONAL SEARCH REPORT

| International application No. |
| --- |
| **PCT/JP2023/027719** |

**A. CLASSIFICATION OF SUBJECT MATTER**

*B32B 15/04*(2006.01)i; *G01N 23/2273*(2018.01)i
FI:   B32B15/04 B; G01N23/2273

According to International Patent Classification (IPC) or to both national classification and IPC

**B. FIELDS SEARCHED**

Minimum documentation searched (classification system followed by classification symbols)

B32B1/00-43/00; G01N23/2273; G01N21/64

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2019-50140 A (SHARP CORP.) 28 March 2019 (2019-03-28) claims, paragraphs [0008]-[0038], [0066]-[0070], [0085]-[0143] | 1-4, 6, 9, 10 |
| Y | | 5, 7, 8 |
| X | JP 2017-77684 A (KONICA MINOLTA, INC.) 27 April 2017 (2017-04-27) claims, paragraphs [0020]-[0041], [0100]-[0153], [0225]-[0279], fig. 1 | 1-5, 7, 9, 10 |
| X | JP 2013-182262 A (SEIKO EPSON CORP.) 12 September 2013 (2013-09-12) claims, paragraphs [0013]-[0032], [0048]-[0051], fig. 1, 2 | 1-5, 9, 10 |
| Y | JP 2014-60273 A (SUMITOMO CHEMICAL CO., LTD.) 03 April 2014 (2014-04-03) claims, paragraphs [0034]-[0165], fig. 2, 3, 7, 8 | 5, 7, 8 |
| L | WO 2008/126523 A1 (TOKYO OHKA KOGYO CO., LTD.) 23 October 2008 (2008-10-23) paragraphs [0087], [0088], [0093], [0094] | 1-5, 9, 10 |
| A | WO 2016/189848 A1 (FUJIFILM CORP.) 01 December 2016 (2016-12-01) entire text | 1-12 |

☑ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **29 September 2023** | **10 October 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
|---|
| **PCT/JP2023/027719** |

### C.     DOCUMENTS CONSIDERED TO BE RELEVANT

| Category* | Citation of document, with indication, where appropriate, of the relevant passages | Relevant to claim No. |
|---|---|---|
| A | JP 2012-74634 A (TOSHIBA CORP.) 12 April 2012 (2012-04-12)<br>      entire text | 1-12 |
| A | US 2006/0017918 A1 (CULLUM, Brian M.) 26 January 2006 (2006-01-26)<br>      entire text | 1-12 |
| A | US 2018/0346673 A1 (AGENCY FOR SCIENCE, TECHNOLOGY AND RESEARCH) 06 December 2018 (2018-12-06)<br>      entire text | 1-12 |

Form PCT/ISA/210 (second sheet) (January 2015)

**EP 4 578 644 A1**

### INTERNATIONAL SEARCH REPORT
Information on patent family members

| International application No. |
| --- |
| **PCT/JP2023/027719** |

| Patent document cited in search report | | | Publication date (day/month/year) | Patent family member(s) | | | Publication date (day/month/year) |
| --- | --- | --- | --- | --- | --- | --- | --- |
| JP | 2019-50140 | A | 28 March 2019 | US 2019/0080870 A1 claims, paragraphs [0005]-[0036], [0080]-[0082], [0104]-[0173] CN 109494139 A | | | |
| JP | 2017-77684 | A | 27 April 2017 | (Family: none) | | | |
| JP | 2013-182262 | A | 12 September 2013 | US 2013/0228549 A1 claims, paragraphs [0025]-[0048], [0070]-[0077], fig. 1, 2 | | | |
| JP | 2014-60273 | A | 03 April 2014 | US 2015/0243931 A1 claims, paragraphs [0057]-[0199], fig. 2A-3, 7A-8 WO 2014/045851 A1 EP 2899767 A1 TW 201418003 A CN 104620393 A KR 10-2015-0056584 A | | | |
| WO | 2008/126523 | A1 | 23 October 2008 | CN 101636256 A KR 10-2009-0117947 A TW 200838939 A JP 2009-56737 A JP 2009-56736 A JP 2008-246876 A | | | |
| WO | 2016/189848 | A1 | 01 December 2016 | US 2018/0095192 A1 CN 107615101 A | | | |
| JP | 2012-74634 | A | 12 April 2012 | US 2012/0073651 A1 US 2014/0182677 A1 | | | |
| US | 2006/0017918 | A1 | 26 January 2006 | (Family: none) | | | |
| US | 2018/0346673 | A1 | 06 December 2018 | WO 2016/080918 A1 SG 11201704003P A | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8271431 A

**Non-patent literature cited in the description**

- *Particle Diameter Measurement Technique*, 1994, 5